# EUROPEAN PATENT APPLICATION

(11) **EP 1 826 820 A1**
(43) Date of publication of application: **29.08.2007**
(21) Application number: 05814578.0
(22) Date of filing: 06.12.2005
(51) Int. Cl.: H01L 27/14, G02B 3/00

(54) **SOLID-STATE IMAGE PICKUP DEVICE AND MASK MANUFACTURING METHOD**

(30) Priority: 15.12.2004 JP 2004362849
(71) Applicant: MATSUSHITA ELECTRIC INDUSTRIAL CO., LTD., Osaka 571-8501 (JP)
(72) Inventor: MASUYAMA, Masayuki, Matsushita Electric Ind.Co.,Ltd., Osaka-shi, Osaka 540-6319 (JP); UETA, Atsushi, Matsushita Electric Ind.Co.,Ltd., Osaka-shi, Osaka 540-6319 (JP)
(74) Representative: Pautex Schneider, Nicole Véronique
(86) International application number: PCT/JP2005/022382
(87) International publication number: WO 2006/064690

(57) **Abstract**

A solid-state image pickup device includes: a light receiving region where photoelectric conversion elements are two- dimensionally arranged; and a microlens layer which has microlenses that introduce incident light into the photoelectric conversion elements. The microlens layer has a plurality of regions each having different microlens pitches. At least one region has a plurality of microlenses, and a pitch of the microlenses is different from a pitch of the photoelectric conversion elements.

## Description

### Technical Field

The present invention relates to a solid-state image pickup device which includes light receiving region where photoelectric conversion elements are two-dimensionally arranged, and microlenses each corresponding to the photoelectric conversion elements. The present invention particularly relates to a solid-state image pickup device which includes a microlens layer where microlenses are arranged to be deviated from locations directly above the photoelectric conversion elements toward the optical center of the light receiving region.

### Background Art

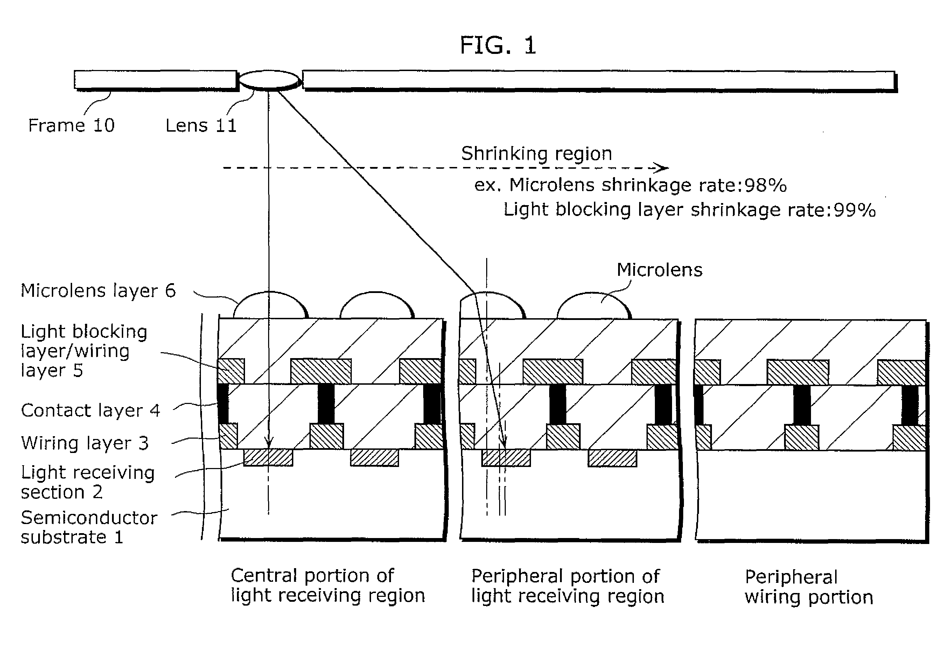

FIG. 1 is a cross sectional view of a conventional solid-state image pickup device disclosed in Patent Document 1 and the like. In the solid-state image pickup device, FIG. 1 partially illustrates a central portion of the light receiving region, a peripheral portion within the light receiving region, and a peripheral wiring portion outside the light receiving region. The solid-state image pickup device includes a semiconductor substrate 1, wiring layers 3, contact layers 4, light blocking layers/wiring layers 5, and microlens layers 6. The semiconductor substrate 1 includes light receiving sections 2 which are two-dimensionally arranged. Each of the microlens layers 6 collects light. As shown in the figure, the light from a lens 11 provided in an opening of a camera frame 10 is made incident on the central portion of the light receiving region substantially perpendicularly. However, the incident angle becomes larger toward the peripheral portion within the light receiving region. The peripheral portion, on which only oblique light is made incident, receives a smaller amount of light than the central portion. In order to improve this, microlenses are arranged so as to have a pitch smaller than the pitch of the light receiving sections 2 and to deviate toward the central portion with distance from the central portion. For example, toward the optical center, the size of the microlens layer 6 is shrunk (reduced) by 99 percent, and the size of the light blocking layer/wiring layer 5 is shrunk by 98 percent.

In the conventional solid-state image pickup device disclosed in Patent Document 2 and the like, a plurality of wiring layers each are deviated toward the central portion at different shrinkage rates (size-reduction rates). This improves the light collection rate of a peripheral portion even with the plurality of wiring layers.

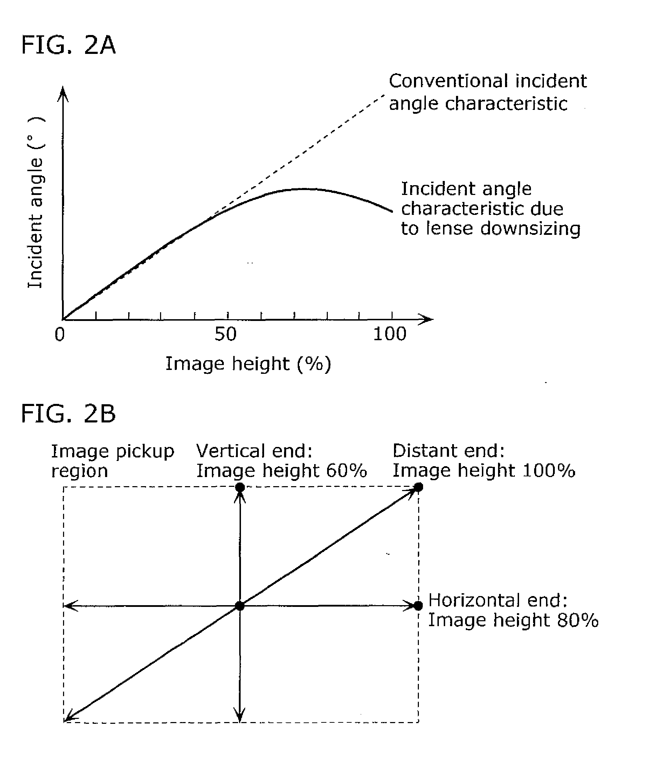

FIG. 2A shows an incident angle characteristic relative to an image height. FIG. 2B illustrates the relation between an image pickup region (light receiving region) and an image height. Referring to FIG. 2B, the area defined by a broken line indicates the image pickup region having an aspect ratio of 4:3. The term "image height" means the distance of an image pickup region from an optical center. Specifically, when an given image height is set as 100 percent at the four corners farthest from the optical center, the image height is 80 percent at the horizontal ends on the right and left sides of the optical center, and 60 percent at the vertical ends above and below the optical center.

The conventional solid-state image pickup devices have the incident angle characteristic indicated by the broken line in FIG. 2A. Specifically, an image height and an incident angle are in proportional relation. Therefore, microlenses are arranged so as to have a pitch smaller than the pitch of the light receiving sections, and to deviate toward the central portion with distance from the central portion.
Patent Document 1: Japanese Patent No. 2600250
Patent Document 2: Japanese Laid-Open Patent Application No. 2001-237404

### Disclosure of Invention

### Problems that Invention is to Solve

Along with the miniaturization of recent cameras typified by a digital camera and a camera built into a mobile phone, their exit pupil distances become shorter. The term "exit pupil" means a virtual image of a lens (lens 11 in FIG.1) or an aperture seen from the side of the light receiving surface of an image pickup region. The term "exit pupil distance" means the distance between the light receiving surface and the lens 11. Due to such a shorter exit pupil distance, the incident angle characteristic of an image pickup region is not always proportional to an image height differently from the conventional cameras. For example, as indicated by the solid line in FIG. 2A, the peripheral portion of an image pickup region sometimes has a smaller incident angle than its inner side in reverse. In view of the example shown in FIG. 2A, the incident angle corresponding to an image height of 80 to 100 percent is smaller than the incident angle corresponding to an image height of 60 to 80 percent. This reversion is caused by the aperture and shape of the lens 11 due to a shorter exit pupil distance.

In the conventional solid-state image pickup devices, however, the microlenses are arranged so as to have a pitch smaller than the pitch of the light receiving sections, and to deviate toward the central portion with distance from the central portion. If an incident angle characteristic is not proportional to an image height, for example, in a case when an incident angle becomes smaller in reverse halfway through, the conventional solid-state image pickup devices are disadvantageous in decreasing their light collection rate.

In light of the foregoing problem, it is an object of the present invention to provide a solid-state image pickup device as well as a mask manufacturing method which improve a light collection rate if an incident angle characteristic is not proportional to an image height.

### Means to Solve the Problems

In order to achieve the above object, the solid-state image pickup device according to the present invention includes: a light receiving region which includes photoelectric conversion elements that are arranged two-dimensionally; and a microlens layer which includes microlens that introduce incident light into the photoelectric conversion elements, wherein said microlens layer has a plurality of regions each of which has a pitch of the microlenses, the pitch being different depending on the region, and at least one of the regions has a plurality of microlenses whose pitch is different from a pitch of the photoelectric conversion elements.

According to this configuration, if an image height and an incident angle characteristic are not in proportional relation, a light collection rate is improved by allowing each of the regions to respond to an actual incident angle.

Further, each of the regions may include a plurality of microlenses, and a pitch of the microlenses may be constant within each of the regions, the pitch being different depending on the region.

According to this configuration, the pitch of the microlenses is constant within each region, and the pitch varies on a region to region basis. This allows each of the regions to respond to an actual incident angle appropriately so as to improve a light collection rate.

Furthermore, the regions may include: a plurality of first regions each having microlenses; and a second region having no microlens, the second region being a boundary region between the first regions, a pitch of the microlenses may be constant within each of the first regions, the pitch being different depending on the region and a pitch of a microlense which are arranged across the second region may be different from the pitch of the other microlenses within the first regions.

According to this configuration, the pitch of the microlenses being arranged across the second region is set appropriately so as to allow each of the first regions to respond to an actual incident angle appropriately, thereby improving a light collection rate.

Still further, the regions may be arranged concentrically.

Still further, the regions may be arranged polygonally.

Still further, the pitches of the microlenses in the respective regions may correspond to respective different incident angles of the incident light.

Moreover, the mask manufacturing method according to the present invention is for manufacturing a mask to be used for manufacturing a solid-state image pickup device which includes a light receiving region having photoelectric conversion elements arranged two-dimensionally. The mask manufacturing method may include steps of: drawing a partial pattern for a first region at a first correction size-reduction rate with reference to an optical center of the light receiving region, the partial pattern for the first region being a part of a pattern above the light receiving region and existing in the first region; and drawing a partial pattern for a second region different from the first region at a second correction size-reduction rate with reference to the optical center of the light receiving region, the partial pattern for the second region being another part of the pattern and existing in the second region, and the second region being different from the first region or having an edge overlapped with the first region.

According to this method, a mask suitable for manufacturing the above solid-state image pickup device is manufactured. Specifically, if an image height and an incident angle characteristic are not in proportional relation, but are brought into reverse relation halfway through, a mask for forming the first region and the second region which deal with the reversion is manufactured.

Further, the first region may be a concentrical region with the optical center as its center, and the second region may be a doughnut-shaped region with the optical center as its center.

Furthermore, the first region may be a polygonal region with the optical center as its center, and the second region may be a polygonal, doughnut-shaped region with the optical center as its center.

Still further, the first correction size-reduction rate may be equal to the second correction size-reduction rate, each of the partial patterns may represent elements which are arranged two-dimensionally and each of which corresponds to the photoelectric conversion elements, and in said drawing for the second region, a pitch of adjacent elements across a boundary between the first region and the second region may be larger than a pitch of the elements within the first region.

Still further, said drawing for the first region and said drawing for the second region may be performed at the same time.

According to this method, the partial patterns are drawn collectively so as to reduce the number of man-hours required for mask manufacturing.

Still further, the first correction size-reduction rate may be different from the second correction size-reduction rate.

Still further, each of the partial patterns in said drawing for the first and second regions may have a layout data for drawing, in which a value obtained by dividing a minimum width as a wiring rule in the solid-state image pickup device manufacturing process by its size-reduction rate is a design rule.

According to this method, even though the solid-state image pickup device is manufactured with a size-reduced pattern drawn on a mask, a minimum width is reserved as the wiring rule in the manufacturing process.

Still further, in said drawing for the first and second regions, the design rule may be applied to wiring drawing, contact drawing for connecting wires together, and microlens drawing as the elements.

### Effects of the Invention

According to the solid-state image pickup device and the mask manufacturing method according to the present invention, even if an image height and an incident angle characteristic are not in proportional relation, a light collection rate is improved.

### Brief Description of Drawings

[FIG. 1] FIG. 1 is a cross sectional view of a conventional solid-state image pickup device.
[FIG. 2A] FIG. 2A shows an incident angle characteristic relative to an image height.
[FIG. 2B] FIG. 2B illustrates the relation between an image pickup region and an image height.
[FIG. 3A] FIG. 3A is a plan view showing image pickup regions divided concentrically.
[FIG. 3B] FIG. 3B is a plan view showing image pickup regions divided rectangularly.
[FIG. 4] FIG. 4 is a cross sectional view of a solid-state image pickup device according to a first embodiment.
[FIG. 5] FIG. 5 is a plan view of the solid-state image pickup device.
[FIG. 6A] FIG. 6A shows the incident angle characteristic for each region.
[FIG. 6B] FIG. 6B shows regions and the boundary between the regions.
[FIG. 7] FIG. 7 is a cross sectional view showing the solid-state image pickup device according to the first embodiment.
[FIG. 8] FIG. 8 is a plan view of the solid-state image pickup device.
[FIG. 9] FIG. 9 shows a mask manufacturing process.

### Numerical References

- 1: Semiconductor substrate
- 2: Light receiving section
- 3: Wiring layer
- 4: Contact layer
- 5: Light blocking layer/wiring layer
- 6: Microlens layer

### Best Mode for Carrying Out the Invention

### (First Embodiment)

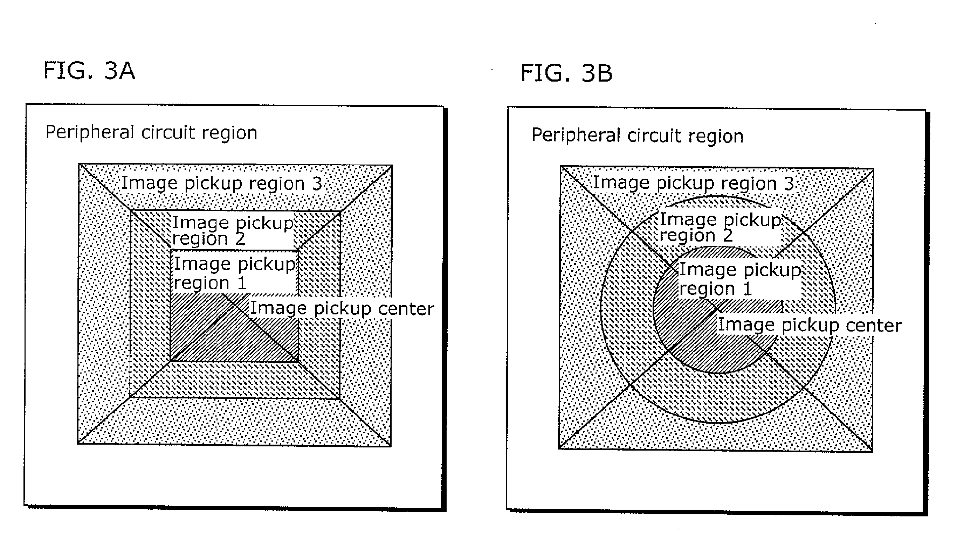

FIG. 3A is a plan view schematically showing a solid-state image pickup device according to a first embodiment of the present invention. As shown in FIG. 3A, the surface of the solid-state image pickup device essentially has a light receiving region and a peripheral circuit region. The light receiving region includes a plurality of regions: image pickup regions 1, 2 and 3. The image pickup regions are separated by a quadrangular boundary with the optical axis center (or optical center) as its center. The image pickup regions 1, 2, and 3 may be separated by a polygonal boundary not by a quadrangular boundary, or alternatively, may be separated by a circular boundary with the optical axis center as its center as shown in FIG. 3B.

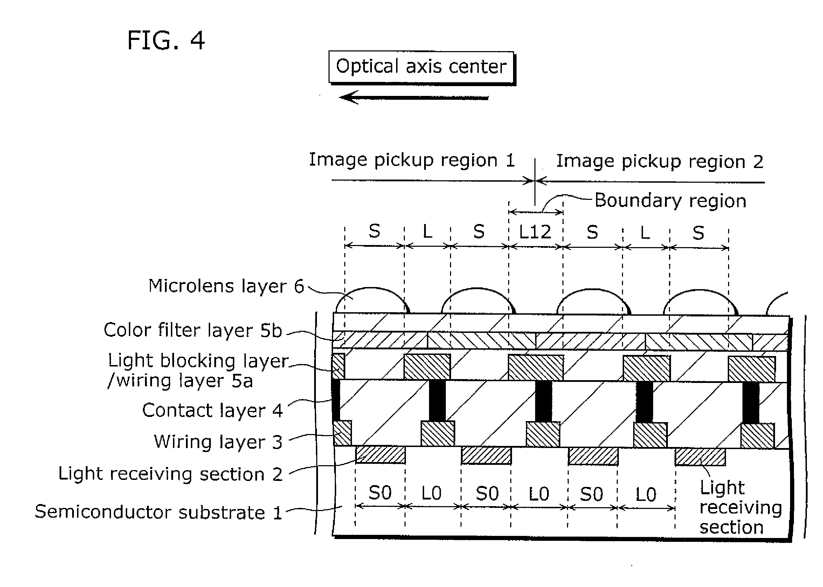

FIG. 4 is a cross sectional view of the solid-state image pickup device. This figure shows only four pixels near the boundary between the image pickup region 1 and the image pickup region 2 shown in FIG. 3A or FIG. 3B. In the figure, the left side is assumed as the optical axis center.

The solid-state image pickup device includes a semiconductor substrate 1, wiring layers 3, contact layers 4, light blocking favors/wiring layers 5a, color filter layers 5b, and microlens layers 6. The semiconductor substrate 1 includes light receiving sections 2 which are two-dimensionally arranged. The microlens layer 6, which collects light, includes a plurality of image pickup regions 1 and 2 each having microlenses, and a boundary region having no microlens between the image pickup regions. The pitch of the microlenses is constant in each of the image pickup regions. All the image pickup regions have their own pitches. However, a pitch of the microlenses arranged across the boundary region, is different from the pitch of the other microlenses in the same image pickup region. Each pitch between the microlenses is smaller than the pitch between the light receiving sections 2 (S0+L0). The microlenses are arranged to deviate toward the optical axis center. The light blocking layer/wiring layer 5a and the contact layer 4 are also arranged to deviate toward the optical axis center. The deviation amount for each pixel (shrinkage rate, or size-reduction rate) becomes smaller in the order of the microlens layer 6, the color filter layer 5b, and the light blocking layer/wiring layer 5a. FIG. 4 shows the size S of each opening portion and the size L of each light blocking portion in the light blocking layer/wiring layer 5a. The size S of each opening portion and the size L of each light blocking portion in the light blocking layer/wiring layer 5a are constant within each of the image pickup regions. The pitch of the opening portions in the light blocking layer/wiring layer 5a is constant (S+L) within each of the image pickup regions, but different from the pitch of the opening portions in the boundary region of the light blocking layer/wiring layer 5a (S+L12).

According to this configuration, if an incident angle characteristic is not proportional to an image height, the microlenses belonging to the second microlens group improve the light collection rate of all the microlenses on their outer periphery side.

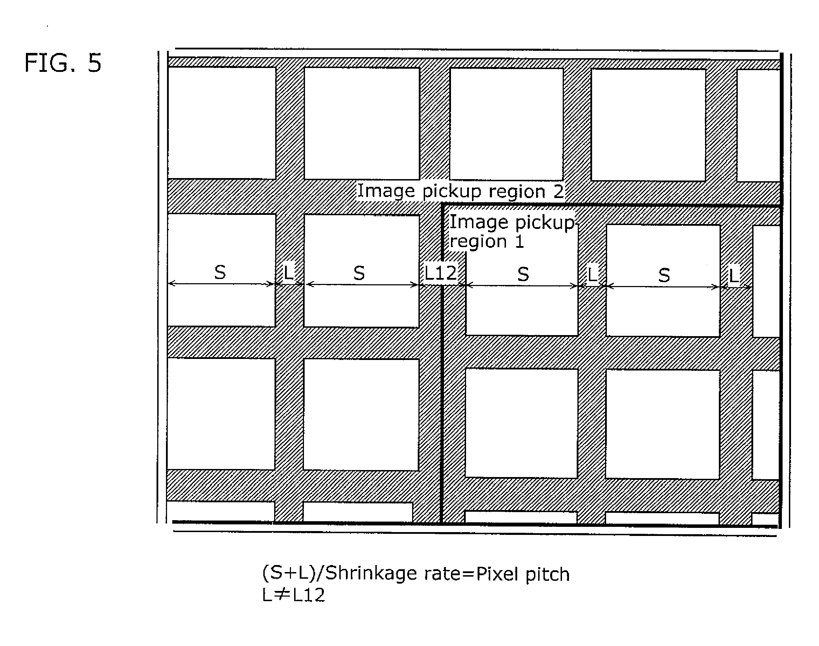

FIG. 5 is an enlarged plan view schematically showing the boundary between the image pickup region 1 and the image pickup region 2 shown in FIG. 3A. FIG. 5 shows a layout of the opening portions in the light blocking layer/wiring layer 5a. In the figure, the character "S" denotes the one side length of each opening portion, and the character "L" denotes the distance between the opening portions within the image pickup region 1 and 2. The character "L12" denotes the distance between the opening portions across the boundary, longer than the distance L. The distances S, L and L12 are horizontal distances. If square pixel cells are employed, their perpendicular distances are the same as the horizontal distances. As a matter of course, the distance in the optical axis center direction is obtained by multiplying the distance in the horizontal or perpendicularly direction by the square root of two. The opening portions are arranged to deviate in the same way as the microlenses. Specifically, the deviation of the opening portions below the microlenses belonging to the second microlens group is smaller than the deviation of the opening portions below the microlenses belonging to the first microlens group.

In other words, the pitch of the adjacent opening portions across the boundary between the image pickup region 1 and the image pickup region 2 (S+L12 in FIG. 5) is larger than the pitch of the opening portions within the image pickup region 1 (S+L). The image pickup region 1 and the image pickup region 2 are the same in the size S of each opening portion and the distance between the opening portions. Therefore, if the layout shown in FIG. 5 is prepared as a mask, the image pickup region 1 and the image pickup region 2 are exposed to light at the same time in the solid-state image pickup device manufacturing process.

The image pickup regions each correspond to the angle of the light incident on each region.

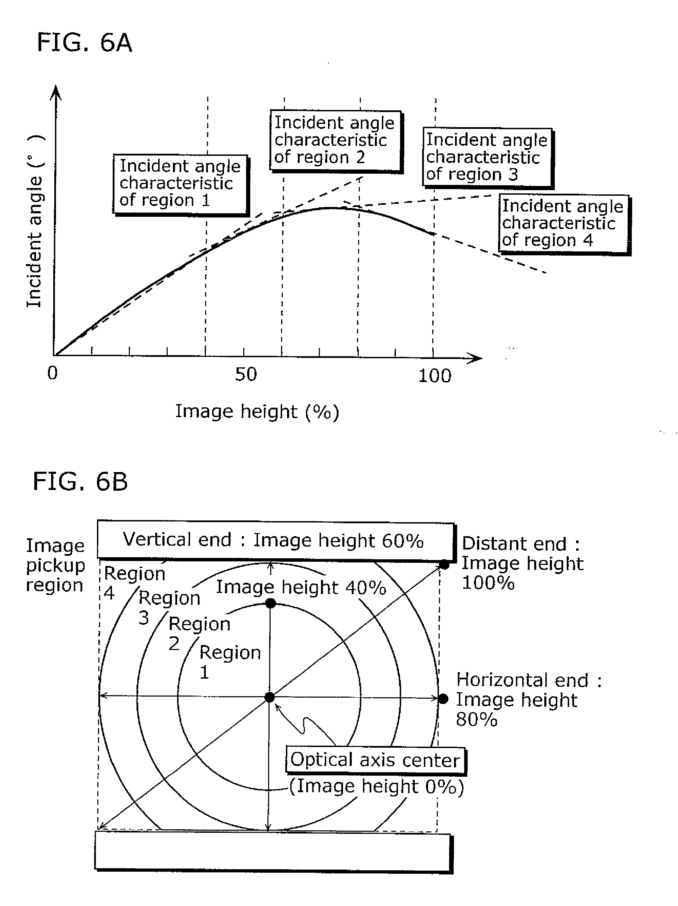

FIG. 6A shows the incident angle characteristics for each of the image pickup regions 1 to 4. FIG. 6B shows the concentrical image pickup regions 1 to 4 corresponding to FIG. 6A. The incident angle characteristic on the image pickup region 1 is the average of image heights of 0 to 40 degrees. The incident angle characteristic on the image pickup region 2 is the average of image heights of 40 to 60 degrees. The incident angle characteristic on the image pickup region 3 is the average of image heights of 60 to 80 degrees. The incident angle characteristic on the image pickup region 4 is the average of image heights of 80 to 100 degrees. The deviation amount of the microlenses in each image pickup region is set at an optimal value for the average incident angles. In the example of FIG. 5, the distance L12 between the opening portions on the boundary is set to obtain an optimal deviation amount.

As has been described above, according to the solid-state image pickup device of this embodiment, if an image height and an incident angle characteristic are not in proportional relation, but are brought into reverse relation halfway through, the light collection rate on the outer side is improved by the microlenses belonging to the second microlens group. In addition, the regions of the number according to the degree of an incident angle are provided so that the microlenses deviate suitably for the incident angle. This deviation is achieved by setting the distance between the microlenses or the distance L12 between the opening portions, across the boundary, to be larger than the corresponding distances within each of the regions.

### (Second Embodiment)

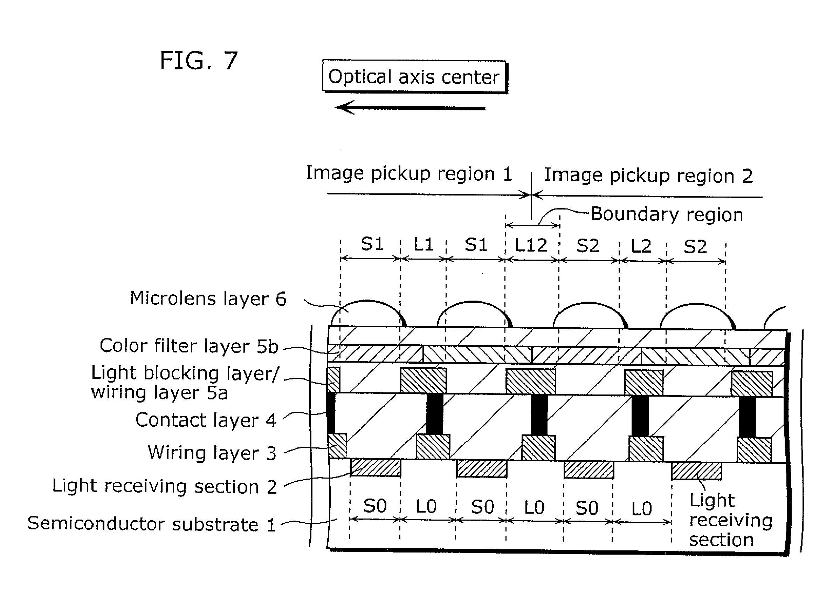

FIG. 7 is a cross sectional view of a solid-state image pickup device according to a second embodiment. This figure is different from the cross sectional view showing the solid-state image pickup device as FIG. 4 in that the distance between the opening portions is referred to as "L1", and the size of each opening portion as "S1" within the image pickup region 1. There is also a difference in that the distance between the opening portions is referred to as "L2", and the size of each opening portion as "S2" within the image pickup region 2. The incident angle characteristic in FIG. 7 is the same as shown in FIG. 6A and FIG. 6B. A description is given mainly for the different points, and the description for the common points is omitted here. The distances L1 and L2 are set at optimal values according to the incident angle characteristics of the image pickup regions 1 and 2. In this example, L2>L1, L12>L1 and L12>=L2. Specifically, the pitch of the opening portions within the image pickup region 1 is smaller than the pitch within the image pickup region 2. The image pickup regions 1 and 2 are different in the opening portion size and the distance between the opening portions. This means that each image pickup region has a different shrinkage rate. The different shrinkage rates for each image pickup region allow the opening portion pitch, the opening portion size and the distance between the opening portions, to be set according to the incident light characteristic for each image pickup region.

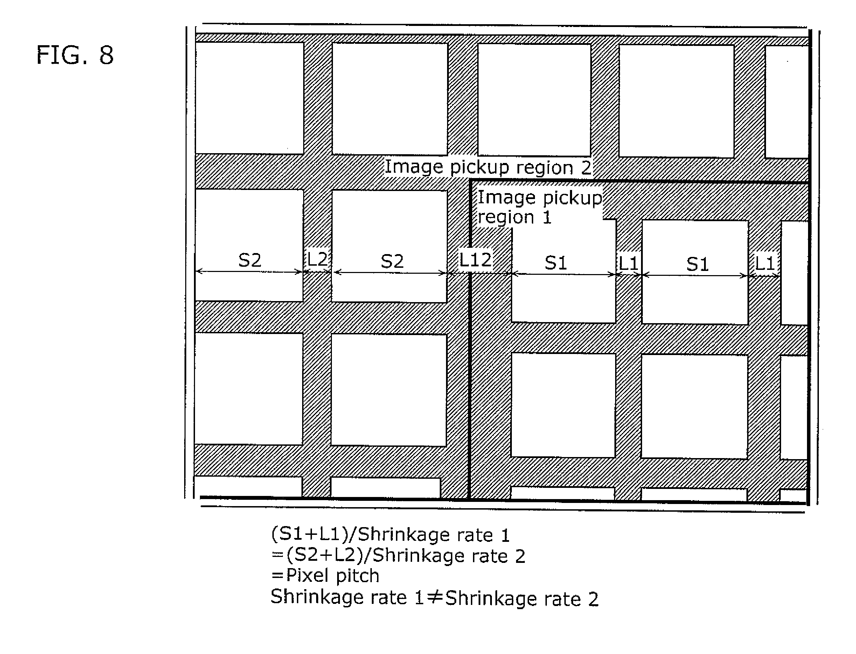

FIG. 8 is a plan view of the solid-state image pickup device. FIG. 8 is different from the plan view of FIG. 5 in that the distance between the opening portions is referred to as "L1", and the size of each opening portion as "S1" within the image pickup region 1. There is also a difference in that the distance between the opening portions is referred to as "L2", and the size of each opening portion as "S2" within the image pickup region 2.

Hereinafter, a description is given for a manufacturing method of the mask to be used for manufacturing the solid-state image pickup device according to the first and second embodiments.

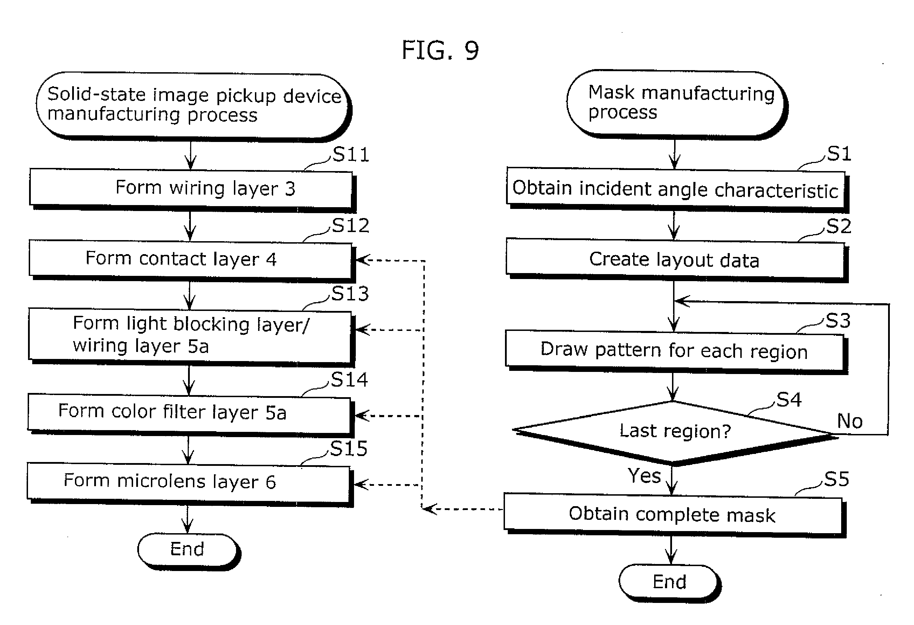

FIG. 9 is a flow chart showing a mask manufacturing process and a solid-state image pickup device manufacture process. This figure mainly shows the mask manufacturing process in the light receiving region. The description for the wiring region around the light receiving region is omitted here.

In a mask manufacturing process, an incident angle characteristic is obtained in the apparatus to contain the solid-state image pickup device (S1), and the light receiving region is then divided into a plurality of regions based on the incident angle characteristic (S2). In this case, the light receiving region is divided according to incident angle characteristics as shown in FIGS. 6A and 6B. In this case, the light receiving region may be divided into a plurality of regions concentrically with the optical center as its center as shown in FIG. 3B, may be divided quadrangularly with the optical center as its center as shown in FIG. 3A, or alternatively may be divided polygonaly. The position of the dividing line in the light receiving region, specifically, the position of the boundary between regions corresponds to a light-blocked portion between pixels for the light blocking layer/wiring layer 5a. Furthermore, the region boundary is determined so that adjacent regions overlap each other in the light-blocked portion. For the wiring layer 3 and the microlens layer 6, the dividing line is preferably positioned in a space portion.

Next, layout data is created for each region (S2). The layout data defines the layout of the elements within each of the divided regions. Respective patterns denote elements to be arranged two-dimensionally corresponding to the photoelectric conversion elements. In this case, the elements include a microlens, a wiring line, a light blocking wiring line, and a contact.

Then, a pattern is drawn on a glass substrate to be an actual mask based on the layout data for each region (S3 and S4). The pattern drawing is performed by coating the glass substrate with a material for a reflection film, exposing the coated substrate to light, and then developing the substrate, so as to form a reflection film thereon. In this case, the partial pattern for each of the divided region is drawn by exposing to light, based on the layout data, with reference to the optical center of the light receiving region, at the correction size-reduction rate for each region. More specifically, the pattern for each region has layout data with the value obtained by dividing a minimum width as a wiring rule in the solid-state image pickup device manufacturing process by its size-reduction rate as a design rule. In other words, since the final result drawn by the whole solid-state image pickup device has to be based on the consistent design rule, the layout data before pattern drawing with size reduction has to be applied based on the design rule fitting the correction size-reduction rate. The design rule is applied for contact drawing for connecting wiring lines, wiring layer drawing, color filter drawing, and microlens drawing. In Step S3 and S4, when the pattern for each region is drawn, the pattern drawing is performed so that the pitch of the adjacent elements across the boundary between one region and another region is larger than the pitch of the elements within each region.

When pattern drawing is finished for all the regions, a complete mask is obtained (S5). A single mask is manufactured in each of the following steps included in the solid-state image pickup device manufacturing process: the step of forming the wiring layer 3 ; the step of forming the contact layer 5; the step of forming the light blocking layer/wiring layer 5; and the step of forming the microlens layer 6. Alternatively, one mask may be employed for common use, if applicable.

By employing the masks thus manufactured, the solid-state image pickup device according to the first and second embodiments is manufactured through the following steps: the step of forming the wiring layer 3 (S11); the step of forming the contact layer 4 (S12); the step of forming the light blocking layer/wiring layer 5a (S13); the step of forming the color filter layer 5b (S14); and the step of forming the microlens layer 6 (S15).

According to the above mask manufacturing process, a mask suited for manufacturing the above solid-state image pickup device is manufactured. Specifically, if an image height and an incident angle characteristic are not in proportional relation, but are brought into reverse relation halfway through, a mask for forming a plurality of regions which deal with the reversion is manufactured.

If there are a plurality of regions to be drawn at the same correction size-reduction rate, pattern drawing may be performed collectively instead of the individual drawing processes to be performed in Steps S4 and S5. The regions are exposed to light at the same time so as to improve efficiency.

### Industrial Applicability

The present invention is suitable for a solid-state image pickup device having microlenses included in each of the light-receiving elements formed on a semiconductor substrate, a manufacturing method of a mask used for manufacturing the solid-state image pickup device, and a camera having the solid-state image pickup device. Examples of the present invention's application include a CCD image sensor, an MOS image sensor, a digital still camera, a mobile phone with a camera, a camera built into a notebook computer, and a camera unit to be connected to information processing equipment.

## Claims

1. The solid-state image pickup device according to claim 1, comprising: a light receiving region which includes photoelectric conversion elements that are arranged two-dimensionally; and a microlens layer which includes microlens that introduce incident light into the photoelectric conversion elements,
wherein said microlens layer has a plurality of regions each of which has a pitch of the microlenses, the pitch being different depending on the region, and
at least one of the regions has a plurality of microlenses whose pitch is different from a pitch of the photoelectric conversion elements.

2. The solid-state image pickup device according to claim 1,
wherein each of the regions includes a plurality of microlenses, and
a pitch of the microlenses is constant within each of the regions, the pitch being different depending on the region.

3. The solid-state image pickup device according to claim 2,
wherein the regions are arranged concentrically.

4. The solid-state image pickup device according to claim 2,
wherein the regions are arranged polygonally.

5. The solid-state image pickup device according to claim 2,
wherein the pitches of the microlenses in the respective regions correspond to respective different incident angles of the incident light.

6. The solid-state image pickup device according to claim 1,
wherein the regions include: a plurality of first regions each having microlenses; and a second region having no microlens, the second region being a boundary region between the first regions,
a pitch of the microlenses is constant within each of the first regions, the pitch being different depending on the region and
a pitch of a microlense which are arranged across the second region is different from the pitch of the other microlenses within the first regions.

7. The solid-state image pickup device according to claim 6,
wherein the regions are arranged concentrically.

8. The solid-state image pickup device according to claim 6,
wherein the regions are arranged polygonally.

9. The solid-state image pickup device according to claim 6,
wherein the pitches of the microlenses in the respective regions correspond to respective different incident angles of the incident light.

10. A mask manufacturing method for manufacturing a mask to be used for manufacturing a solid-state image pickup device which includes a light receiving region having photoelectric conversion elements arranged two-dimensionally, said method comprising steps of:
drawing a partial pattern for a first region at a first correction size-reduction rate with reference to an optical center of the light receiving region, the partial pattern for the first region being a part of a pattern above the light receiving region and existing in the first region; and
drawing a partial pattern for a second region different from the first region at a second correction size-reduction rate with reference to the optical center of the light receiving region, the partial pattern for the second region being another part of the pattern and existing in the second region, and the second region being different from the first region or having an edge overlapped with the first region.

11. The mask manufacturing method according to claim 10,
wherein the first region is a concentrical region with the optical center as its center, and
the second region is a doughnut-shaped region with the optical center as its center.

12. The mask manufacturing method according to claim 11,
wherein the first correction size-reduction rate is equal to the second correction size-reduction rate,
each of the partial patterns represents elements which are arranged two-dimensionally and each of which corresponds to the photoelectric conversion elements, and
in said drawing for the second region, a pitch of adjacent elements across a boundary between the first region and the second region is larger than a pitch of the elements within the first region.

13. The mask manufacturing method according to claim 11,
wherein said drawing for the first region and said drawing for the second region are performed at the same time.

14. The mask manufacturing method according to claim 11,
wherein the first correction size-reduction rate is different from the second correction size-reduction rate.

15. The mask manufacturing method according to claim 11,
wherein each of the partial patterns in said drawing for the first and second regions has a value obtained by dividing a minimum width as a wiring rule in the solid-state image pickup device manufacturing process by its size-reduction rate as a design rule, and
the design rule is applied to at least one of wiring drawing, contact drawing for connecting wires together, and microlens drawing as the elements.

16. The mask manufacturing method according to claim 10,
wherein the first region is a polygonal region with the optical center as its center, and
the second region is a polygonal, doughnut-shaped region with the optical center as its center.

17. The mask manufacturing method according to claim 16,
wherein the first correction size-reduction rate is equal to the second correction size-reduction rate,
each of the partial patterns represents elements which are arranged two-dimensionally and each of which corresponds to the photoelectric conversion elements, and
in said drawing for the second region, a pitch of adjacent elements across a boundary between the first region and the second region is larger than a pitch of the elements within the first region.

18. The mask manufacturing method according to claim 16,
wherein said drawing for the first region and said drawing for the second region are performed at the same time.

19. The mask manufacturing method according to claim 16,
wherein the first correction size-reduction rate is different from the second correction size-reduction rate.

20. The mask manufacturing method according to claim 16,
wherein each of the partial patterns in said drawing for the first and second regions has a value obtained by dividing a minimum width as a wiring rule in the solid-state image pickup device manufacturing process by its size-reduction rate as a design rule, and
the design rule is applied to at least one of wiring drawing, contact drawing for connecting wires together, and microlens drawing as the elements.

## Amended claims

### Amended claims under Art. 19.1 PCT

**1.** amended) A solid-state image pickup device comprising: a light receiving region which includes photoelectric conversion elements that are arranged two-dimensionally; and a microlens layer which includes microlens that introduce incident light into the photoelectric conversion elements,
wherein said microlens layer has a plurality of regions each of which has a pitch of the microlenses, the pitch being different depending on the region, and
at least one of the regions has a plurality of microlenses whose pitch is different from a pitch of the photoelectric conversion elements.

**2.** The solid-state image pickup device according to claim 1,
wherein each of the regions includes a plurality of microlenses, and
a pitch of the microlenses is constant within each of the regions, the pitch being different depending on the region.

**3.** The solid-state image pickup device according to claim 2,
wherein the regions are arranged concentrically.

**4.** The solid-state image pickup device according to claim 2,
wherein the regions are arranged polygonally.

**5.** The solid-state image pickup device according to claim 2,
wherein the pitches of the microlenses in the respective regions correspond to respective different incident angles of the incident light.

**6.** The solid-state image pickup device according to claim 1,
wherein the regions include: a plurality of first regions each having microlenses; and a second region having no microlens, the second region being a boundary region between the first regions,
a pitch of the microlenses is constant within each of the first regions, the pitch being different depending on the region and
a pitch of a microlense which are arranged across the second region is different from the pitch of the other microlenses within the first regions.

**7.** The solid-state image pickup device according to claim 6,
wherein the regions are arranged concentrically.

**8.** The solid-state image pickup device according to claim 6,
wherein the regions are arranged polygonally.

**9.** The solid-state image pickup device according to claim 6,
wherein the pitches of the microlenses in the respective regions correspond to respective different incident angles of the incident light.

**10.** amended) A mask manufacturing method for manufacturing a mask to be used for manufacturing a solid-state image pickup device which includes a light receiving region having photoelectric conversion elements arranged two-dimensionally, said method comprising steps of:
drawing a partial pattern for a first region at a first correction size-reduction rate with reference to an optical center of the light receiving region, the partial pattern for the first region being a part of a pattern above the light receiving region and existing in the first region; and
drawing a partial pattern for a second region at a second correction size-reduction rate with reference to the optical center of the light receiving region, the partial pattern for the second region being another part of the pattern and existing in the second region, and the second region being different from the first region or having an edge overlapped with the first region.

**11.** The mask manufacturing method according to claim 10,
wherein the first region is a concentrical region with the optical center as its center, and
the second region is a doughnut-shaped region with the optical center as its center.

**12.** The mask manufacturing method according to claim 11,
wherein the first correction size-reduction rate is equal to the second correction size-reduction rate,
each of the partial patterns represents elements which are arranged two-dimensionally and each of which corresponds to the photoelectric conversion elements, and
in said drawing for the second region, a pitch of adjacent elements across a boundary between the first region and the second region is larger than a pitch of the elements within the first region.

**13.** The mask manufacturing method according to claim 11,
wherein said drawing for the first region and said drawing for the second region are performed at the same time.

**14.** The mask manufacturing method according to claim 11,
wherein the first correction size-reduction rate is different from the second correction size-reduction rate.

**15.** The mask manufacturing method according to claim 11,
wherein each of the partial patterns in said drawing for the first and second regions has a value obtained by dividing a minimum width as a wiring rule in the solid-state image pickup device manufacturing process by its size-reduction rate as a design rule, and
the design rule is applied to at least one of wiring drawing, contact drawing for connecting wires together, and microlens drawing as the elements.

**16.** The mask manufacturing method according to claim 10,
wherein the first region is a polygonal region with the optical center as its center, and
the second region is a polygonal, doughnut-shaped region with the optical center as its center.

**17.** The mask manufacturing method according to claim 16,
wherein the first correction size-reduction rate is equal to the second correction size-reduction rate,
each of the partial patterns represents elements which are arranged two-dimensionally and each of which corresponds to the photoelectric conversion elements, and
in said drawing for the second region, a pitch of adjacent elements across a boundary between the first region and the second region is larger than a pitch of the elements within the first region.

**18.** The mask manufacturing method according to claim 16,
wherein said drawing for the first region and said drawing for the second region are performed at the same time.

**19.** The mask manufacturing method according to claim 16,
wherein the first correction size-reduction rate is different from the second correction size-reduction rate.

**20.** The mask manufacturing method according to claim 16,
wherein each of the partial patterns in said drawing for the first and second regions has a value obtained by dividing a minimum width as a wiring rule in the solid-state image pickup device manufacturing process by its size-reduction rate as a design rule, and
the design rule is applied to at least one of wiring drawing, contact drawing for connecting wires together, and microlens drawing as the elements.
